(19) Europäisches Patentamt
European Patent Office
Office européen des brevets

(11) **EP 3 158 676 B1**

(12) **EUROPEAN PATENT SPECIFICATION**

(45) Date of publication and mention
of the grant of the patent:
**28.11.2018 Bulletin 2018/48**

(21) Application number: **14744035.8**

(22) Date of filing: **22.07.2014**

(51) Int Cl.:
*H04L 7/00* (2006.01)      *H03L 7/087* (2006.01)

(86) International application number:
**PCT/EP2014/065666**

(87) International publication number:
**WO 2016/012036 (28.01.2016 Gazette 2016/04)**

(54) **TIMING RECOVERY IN DIRECT-DETECTION MLSE RECEIVERS**

TAKTRÜCKGEWINNUNG IN DIREKT-DETEKTIONS-MLSE-EMPFÄNGERN

RÉCUPÉRATION DU RYTHME DANS DES RÉCEPTEURS D'ESTIMATEURS DE SÉQUENCE À MAXIMUM DE VRAISEMBLANCE (MLSE) À DÉTECTION DIRECTE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**26.04.2017 Bulletin 2017/17**

(73) Proprietor: **Huawei Technologies Co., Ltd.
Longgang District
Shenzhen, Guangdong 518129 (CN)**

(72) Inventors:
• **STOJANOVIC, Nebojsa**
**80992 Munich (DE)**
• **XIE, Changsong**
**80992 Munich (DE)**

(74) Representative: **Körber, Martin Hans et al
Mitscherlich PartmbB
Patent- und Rechtsanwälte
Sonnenstrasse 33
80331 München (DE)**

(56) References cited:
**US-A- 3 993 956        US-A- 5 838 797
US-A1- 2006 140 324     US-A1- 2008 232 531
US-A1- 2012 033 773     US-A1- 2012 121 274
US-B1- 6 968 021**

**Description**

**FIELD OF THE INVENTION**

The invention is related to direct detection optical receivers generally and to such receivers using enhanced digital equalizers for chromatic dispersion compensation in particular.

**BACKGROUND OF THE INVENTION**

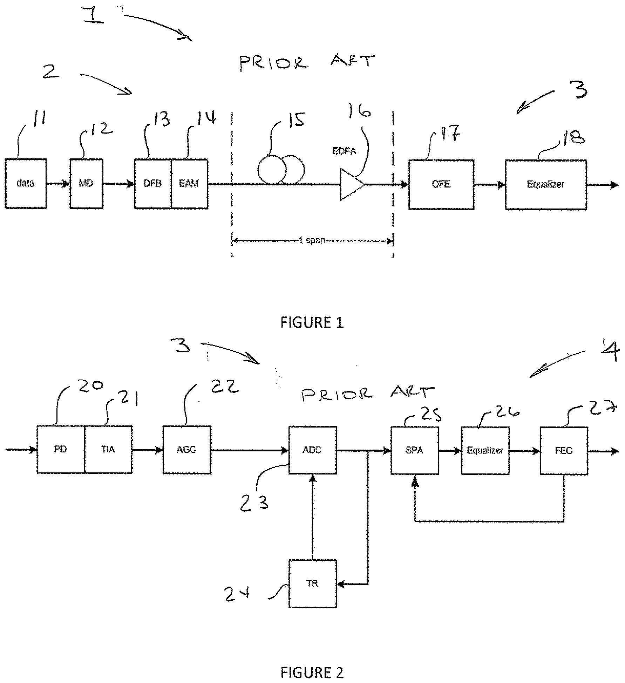

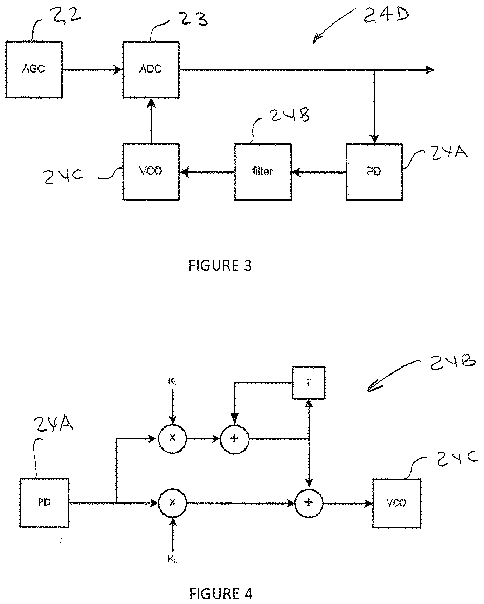

Many 10Gb/s optical transmission systems using the third window (wavelengths around 1550 nm) for transmitting data over optical fibers are deployed in dispersion compensated links. These dispersion compensated links may include dispersion compensating fibers (DCF) which correct for chromatic dispersion (CD) in the transmitted signal as it travels along an optical fiber and which may affect the transmitted data by broadening the signal. The optical fibers used for data transmission typically have a dispersion coefficient close to 16ps/(nm.km). Generally, the DCFs have opposite dispersion sign than the optical fibers through which the data is transmitted and, as they are normally shorter than one optical span (~80km), have a higher dispersion coefficient. The higher dispersion coefficient may produce some negative effects, such as, for example, higher noise, nonlinear effects, and demand for greater power requirements.
In the last years, attempts are being made to have 40 and 100Gb/s optical transmission systems deployed without DCFs. These systems generally employ coherent detection and use digital signal processing (DSP) to compensate for the chromatic dispersion. Nevertheless, these optical transmission systems are very expensive. In shorter optical links without DCF, it is generally not economically feasible to deploy such expensive systems.
Several known techniques for transmitting 10Gb/s data over CD uncompensated optical links focus on improving performance on the transmitting side of the optical transmission system. These techniques may include use of an On-off keying signal (OOK), a Duobinary transmitter, or a Chirped modulated laser. On the receiving side of the transponder, the equalizer may include a feed-forward equalizer (FFE), a decision feed-back equalizer (DFE), a maximum likelihood sequence estimator (MLSE), or any combination thereof.
Some transmissions systems may use on the transmitter side a distributed feedback laser (DFB) together with an electro-absorption modulator (EAM) integrated in transmit optical subassemblies (TOSA). The power of the optical signal may be substantially proportional to the electrical signal modulating the laser. On the receiver side, a photo diode (PD) may detect the optical signal, with the output of the photo diode substantially proportional to the optical signal power. The photo diode may be, for example, a positive-intrinsic-negative (PIN) diode or an avalanche photo diode. The photo diode output may be amplified using a trans-impedance amplifier (TIA). The photo diode and TIA can be integrated in receive optical subassemblies (ROSA) that may include an automatic gain control circuit (AGC) to adjust electrical signal to an analog-to-digital (ADC) input when electronic equalization is used.
A typical 10Gb/s optical transmission system 1 is presented in Figure 1. On the transmission side 2, data 11 may be amplified using a modulator driver (MD) 12. DFB 13 and EAM 14 are responsible for modulation. Optical signal may be transmitted over several spans consisting of fiber 15 and erbium-doped fiber amplifier 16. On the receiver side 3, an optical front end (OFE) 17 includes a photo detector and amplifier, and may be integrated in ROSA. Signal suffering from CD, PMD, and electrical bandwidth limitations may be equalized in an equalizer 18 using FIR, DFB, MLSE, or any combination thereof.
A typical optical receiver 4 (on receiver side 3) is shown in Figure 2. The received optical signal may be received by a photo diode (PD) 20 and its output amplified by TIA 21. An automatic gain control (AGC) 22 may monitor signal power variations and may produce an almost constant signal swing that may fit into an analog/digital converter (ADC) 23 input range to prevent the signal from being clipped and/or attenuated. An equalizer 26 may recover the signal suffering from noise and intersymbol interference (ISI). Prior to equalizing, a local oscillator may be locked to the input signal, i.e. to the transmitter oscillator responsible for data clocking (the two oscillators must be substantially synchronized - small deviations may be allowed due to imperfect tracking of the transmitter clock source). Clock extraction may be enabled by a phase detector (PD) that may output information whether a sampling clock is higher or lower. Since this information may be noisy due to pattern-dependent noise, amplifier noise, component imperfections, among other noise sources, timing information may be filtered before entering the receiver oscillator, often realized as voltage-controlled oscillator (VCO).
Timing information can be derived from an ADC output signal. A timing recovery circuit (TR) 24, for example as shown in Figure 3 and described further on below, may include a PD 24A, a filter 24B, and a VCO 24C. VCO clock phase may be adjusted using a sampling phase adjustment circuit (SPA) 25. Sampling phase optimization may be supported by a forward error correction circuit (FEC) 27 that may correct a number of FEC input errors.
One timing recovery realization is presented in Fig. 3 which schematically illustrates a closed loop circuit known as a phase locked loop circuit (PLL) 24D. PD 24A output is filtered by loop filter 24B and passed to VCO 24C. The order of PLL 24D depends on the filter used, and may include, for example, a second-order loop filter such as proportional-integral (PI) filter 24B shown in Figure 4. An output of PD 24A is split into two signals which are tuned by a proportional gain coefficient $K_p$ and an integral gain coefficient $K_i$, respectively. The integral part includes an ideal integrator whose output is summed up with the proportional part. The loop may be characterized by a loop bandwidth and a damping factor. Selection of loop parameters may depend on available applications and standards, and may consider tracking transmitter frequency and phase variations within accepted system penalties.

Examples of some phase detectors are described in:

Mueller, K. H., and M. S. Muller, "Timing Recovery in Digital Synchronous Data Receivers", IEEE Transactions on Communications, Vol. 24, 1976, pp. 516 - 531, the phase detectors referred to hereinafter as MMPD;

Alexander, J.D.H., "Clock Recovery from Random Binary Signals", Electronic Letters, Volume 11, Vol. 22, 1975, pp. 540 - 541, referred to hereinafter as APD; and

Gardner, F, "A BPSK/QPSK Timing-Error Detector for Sampled Receivers", IEEE Transactions on Communications, Vol. 34, 1986, pp. 423 - 429, referred to hereinafter as GPD

MMPD works with one sample per symbol and is described for real signals by

$$PD_{out}(k) = x(k+T)sign(x(k)) - x(k)sign(x(k+T))$$

where T is symbol interval. Timing error detector characteristics (TEDC) at a certain sampling phase is the averaged value of the PD output at that sampling phase, and is a periodical function with period T.

APD works on three real samples sampled at distance of $T/2$. The PD output is equal to - 1 if the sign of third sample is different than signs of first two samples and equal to 1 if the sign of first sample is different than signs of last two samples. The output is 0 in all other cases.

GPD uses 3 samples at distance T/2. The PD rule for real signals may be defined by

$$PD_{out}(k) = x(k+T/2)\big(x(k+T) - x(k)\big)$$

.

The synchronization between a communication transmitter and a communication receiver is an important topic for reception and demodulation of communication signals transmitted over a communication channel.

The synchronization is usually performed by the communication receiver upon the basis of the received communication signal. The synchronization can in particular relate to synchronizing sampling time instants of a sampler of the communication receiver onto communication symbols of the received communication signal. This kind of synchronization is often referred to as timing recovery.

For synchronization, a phase-locked loop in the communication receiver can be employed. The phase-locked loop can comprise a phase detector for detecting a phase delay between the communication symbols and the sampling time instants. The phase-locked loop can then adapt the sampling time instants upon the basis of the detected phase delay. Common phase detectors comprise a Mueller and Muller phase detector, an Alexander phase detector, or a Gardner phase detector.

In case of a dispersive communication channel between the communication transmitter and the communication receiver, the received communication signal can suffer from dispersion and/or distortion. Common approaches for synchronization, however, show a limited synchronization performance in such scenarios.

In US 8,466,713 B2, a phase detection approach for synchronization is described. Two phase detectors are used which operate on rising and falling edges of communication symbols.

US 2008/0232531 A1 relates to providing global timing error information derived from timing error information of each data channel. This is achieved, in part, by summing the timing error information from all the data channels and integrating and scaling the resulting sum. The integrated, scaled sum is then added to proportional and integral timing information of each individual data channel.

## SUMMARY OF THE PRESENT INVENTION

It is the object of the invention to provide a timing recovery apparatus for receivers.

This object is achieved by the features of the independent claims. Further implementation forms are apparent from the dependent claims, the description and the figures.

According to a first aspect, the invention relates to a timing recovery apparatus for receivers, the apparatus comprising an analog-to digital converter, ADC, a voltage controlled oscillator, VCO, a feedback loop comprising two parallel branches, each branch comprising at least one interpolation filter and one phase detector; a combiner in said feedback loop to combine a signal from each of said branches; and a feed-forward section having an interpolation filter and a phase detector. An input of the interpolation filter is connected to an output of the interpolation filter in one of the parallel branches of the feedback loop.

In a first implementation form of the apparatus according to the first aspect as such, wherein at least one interpolation filter in each of the branches includes a finite impulse response filter.

In a second implementation form of the apparatus according to the first implementation form of the first aspect, each of the branches additionally includes a multiplier for adjusting the outputs of the phase detectors.

In a third implementation form of the apparatus as such or according to the first implementation form or the second implementation form of the first aspect, wherein the feedback loop additionally includes a phase-locked loop filter.

In a fourth implementation form of the apparatus as such or according to the first implementation form to the third implementation form of the first aspect, the feed-forward section additionally includes a look-up table for interpolating a sampling phase.

In a further implementation form of the apparatus as such or according to the first implementation form to the third implementation form of the first aspect, the feedback loop additionally includes a voltage-controlled oscillator.

In a further implementation form of the apparatus, the feed-forward section additionally includes an unwrap module.

In a further implementation form of the apparatus, the feed-forward section additionally includes a samples location module.

In a further implementation form of the apparatus, the feed-forward section additionally includes an interpolation coefficients module.

In a further implementation form of the apparatus, the feed-forward section additionally includes a buffer.

In a further implementation form of the apparatus, the feed-forward section additionally includes an interpolation module.

The invention can be implemented in hardware and/or software.

## BRIEF DESCRIPTION OF THE DRAWINGS

The subject matter regarded as the invention is particularly pointed out and distinctly claimed in the concluding portion of the specification. The invention, however, both as to organization and method of operation, together with objects, features, and advantages thereof, may best be understood by reference to the following detailed description when read with the accompanying drawings in which:

Figure 1 schematically illustrates a block diagram of a typical lOGb/s optical transmission system;

Figure 2 schematically illustrates a block diagram of a typical optical receiver;

Figure 3 schematically illustrates a block diagram of a typical timing recovery circuit;

Figure 4 schematically illustrates a block diagram of a second-order, proportional-integral, loop filter;

Figure 5 is a graph showing simulation results of TEDCMAX for different values of CD for an APD, GPD, and MMPD;

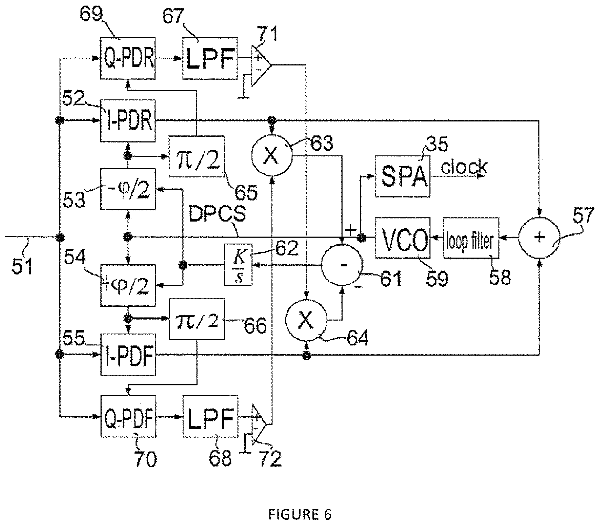

Figure 6 schematically illustrates a known phase detector including two Alexander PDs that work on rising and falling signal edges;

Figure 7A schematically illustrates a block diagram of an exemplary timing recovery circuit, according to an embodiment of the present invention;

Figure 7B schematically illustrates a block diagram of an exemplary timing recovery circuit, according to an embodiment of the present invention;

Figure 8 is a graph showing simulation results of root mean square Jitter against chromatic dispersion for different PLL bandwidths, according to an embodiment of the present invention;

Figure 9 schematically illustrates a block diagram of an optical transmission system test set-up, according to an embodiment of the present invention;

Figure 10A is a graph showing TEDC curves measured for a MMPD and plots TEDC per block on a vertical axis against t/T in a horizontal axis; and

Figure 10B is a graph showing TEDC curves measured for a new phase detector including a timing recovery circuit and plots TEDC per block on a vertical axis against t/T in a horizontal axis, according to an embodiment of the present invention.

It will be appreciated that for simplicity and clarity of illustration, elements shown in the figures have not necessarily been drawn to scale. For example, the dimensions of some of the elements may be exaggerated relative to other elements for clarity. Further, where considered appropriate, reference numerals may be repeated among the figures to indicate corresponding or analogous elements.

## DETAILED DESCRIPTION OF THE PRESENT INVENTION

In the following detailed description, numerous specific details are set forth in order to provide a thorough understanding of the invention. However, it will be understood by those skilled in the art that the present invention may be practiced without these specific details. In other instances, well-known methods, procedures, and components have not been described in detail so as not to obscure the present invention.

In CD uncompensated links using direct detection the transmission distance is generally limited by the capability of electronic dispersion compensation and timing recovery. This is generally caused by ISI resulting from the CD signal spreading. The CD transfer function may be described by

$$H(j\omega) = \exp\left(j\omega^2 K\right) \qquad (1)$$

where the parameter K includes fiber CD parameter, fiber length, speed of light and carrier frequency. Since the exponent includes the square of the frequency, the CD ISI effect is 4 times worse in systems when carrier frequency is doubled. For example, 10Gb/s systems can transmit over 80 km without receiver equalization, but for 20Gb/s systems, transmission may be feasible only over links up to 20 km. Although the limitation in transmission distance is generally associated with BER (bit error rate) performance, timing recovery at the limits may be affected by substantial jitter and reception may be affected by symbol slips.

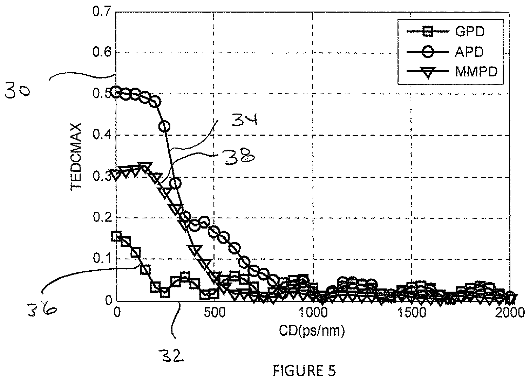

Estimating a maximum TEDC (TEDCMAX) may serve as a good indicator of timing recovery failing area, with small TEDCMAX values indicative of possible weak points. Applicants used simulation to estimate TEDCMAX for different values of CD for each type of detector previously mentioned - APD, GPD, and MMPD. In the simulation, OOK transmitter and direct detection (DD) receiver bandwidths were approximately 10 GHz, baud rate was 28GB/s, and OSNR=22dB. Graphical results of the simulation are shown in Figure 5 which shows TEDCMAX values on y-axis 30 plotted against CD values on x-axis 32. The estimated values for the APD are indicated by curve 34, for the GPD are indicated by curve 36 and for the MMPD by curve 38. It may be appreciated from the graph that clock tone is getting weaker at higher CD values. Additionally, it may be appreciated that all PDs are particularly sensitive to specific CD values (e.g. 1050ps/nm).

Applicants have realized that more effective symbol timing synchronization may be achieved by means of a timing recovery circuit (TR) which includes two parallel branches having a matched interpolation filter and a phase detector in each branch. Using one or two samples per symbol, a quasi-sinusoidal output may be generated by each phase detector which may be combined into a phase error signal which is filtered and fed to a VCO in a PLL configuration (feedback loop).

Applicants have further realized that the TR may be used with receivers in CD uncompensated links which suffer from noise and intersymbol interference (ISI) by including a third matched interpolation filter connected to a third phase detector in a feed-forward timing recovery configuration. In this configuration, an output of one of the interpolation filters in the feedback loop is connected to the third interpolation filter. A quasi-cosinusoidal output generated by the third phase detector is compared with the quasi-sinusoidal output from the phase detector in the feedback loop and the result of the comparison is used to generate an accurate sampling phase from a look-up table storing phase values associated with the result of the comparison. The sampling phase may then be used with an interpolator to allow for more effective timing recovery.

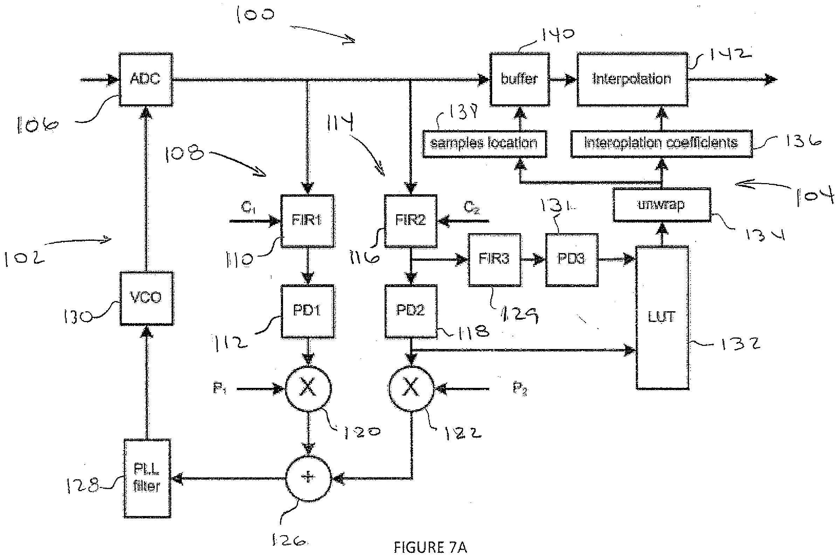

Reference is now made to Figure 7A which schematically illustrates a block diagram of an exemplary TR 100, according to an embodiment of the present invention. TR 100 may be included in an optical receiver of an optical transmission system, including a receiver section of an optical transceiver or an optical transponder. The receiver may include a direct detection MLSE receiver. TR 100 may be used to extract clock tone from a noisy and dispersive optical signal for timing synchronization.

TR 100 may include a feedback section 102 and a feed-forward section 104. Feedback section 102 may extract sinusoidal phase error from symbols associated with a received signal at the output of an analog-to-digital converter ADC 106. ADC 106 may be functionally similar to ADC 23 in receiver 4 shown in Figure 2. The extracted phase error may be used to adjust an oscillator to approximate the phase of the transmitted signal. Feed-forward section 104 may be used to more accurately interpolate the phase of the transmitted signal (optimizing phase adjustment) by allowing phase tracking over a greater symbol interval. Timing information may be interpolated from one or two samples per symbol. When one sample is used, interpolation may be used to approximate the second sample. In this case, interpolation coefficients are fixed. The second sample may be used during the MLSE channel acquisition phase and, once the channel is acquired, the second sample may no longer be used.

Feedback section 102 may include two parallel branches connected to an output of ADC 106, a first parallel branch 108 having a first interpolation filter FIR1 110 and a phase detector PD1 112, and a second parallel branch 114 having a second interpolation filter FIR2 116 and a second phase detector 118. Each branch 108 and 110 may additionally include a multiplier 120 and 122 connected to the outputs of PD1 112 and PD2 118, respectively. Feedback section 102 may additionally include a combiner 126, a PLL filter 128 and a VCO 130. PLL filter 128 and VCO 130 and may be functionally similar to filter 24B and VCO 24C, respectively, shown in Figures 3 and 4.

Interpolation filters FIR1 110 and FIR2 116 may be matched filters and may be finite impulse response filters used for interpolation. Control signals C1 and C2 may be used to set the coefficients of FIR1 112 and FIR2 114. The length and the coefficient values may take into consideration channel conditions and oversampling rate. FIR1 110 coefficients may be described by the following polynomial:

$$\left(1+D\right)^{2n}, n = 0, 1, 2, ... \qquad (2)$$

where D denotes a delay of $T$.

When phase extraction is based on two samples per symbol, FIR2 116 coefficients may be described by the following polynomial:

$$\left(1+D\right)\left(1+D\right)^{2n} = \left(1+D\right)^{2n+1}, n = 0, 1, 2, ... \qquad (3)$$

When phase extraction is based on one sample per symbol, FIR2 116 may roughly interpolate the signal to get the second sample that is used in PD2 118. In this case FIR2 116 coefficients may be described by the same polynomial as for FIR1 110, although they may not have a same $n$ value. For example, FIR1 110 coefficients may be (1, 2, 1) while FIR2 116 coefficients may be (1, 4, 6, 4, 1).

PD1 112 and PD2 118 may be similar phase detectors and may use one sample per symbol, each sample at a distance T/2. The quasi-sinusoidal output signals from each of the phase detectors may be combined by combiner 126 to control the phase and frequency of VCO 130. Therefore, the parallel arrangement of FIR1 110 and PD1 112 with FIR2 116 and PD2 118 may be viewed from the output of combiner 126 as a single phase detector working with two samples per symbol. The combined signal with the timing information from combiner 126 may be fed to PLL filter 128 which may suppress noise in the phase error signal prior to it being fed to VCO 130.

The single phase detector may be described by:

$$y_{out}(n) = abs\left(x(n)\right)^{k} sign(x(n))sign(x(n+2)) - abs\left(x(n+2)\right)^{k} sign(x(n+2))sign(x(n))$$
$$-abs\left(x(n+1)\right)^{k} sign(x(n+1))sign(x(n+3)) + abs\left(x(n+3)\right)^{k} sign(x(n+3))sign(x(n+1)) \quad (4)$$

where samples $x$ are samples at a distance of $T$/2. Parameter $k$ may be selected to minimize jitter, and the selection may depend on channel conditions such as, for example, fiber parameters, link length, OSNR, among others. Optimum values of k may be in the range between 0.5 and 2. To calculate the value abs$(x)^k$, a look-up table (LUT) may be used which may apply known algorithms to calculate the value. For example, if ADC 106 delivers $m$ bits per sample, the LUT may be of size $2^{m-1}$ x $n$ where $n$ is related to the greed of parameter k.

Multipliers 120 and 122 may adjust the outputs from PD1 112 and PD2 118 by parameters P1 and P2, respectively, for better controlling filtering bandwidth and improving timing recovery. When $P_2$ is set to 0, only one sample per symbol is used for timing extraction, although this may result in worse clock performance (increased jitter). A reasonable trade-off may be to select the values of both parameters $P_1$ and $P_2$ to be similar.

Feed-forward section 110 may include an interpolation filter FIR3 129 connected to a phase detector PD3 131, and a look-up table (LUT) 132. Feed-forward section 110 may additionally include an unwrap module 134, an interpolation coefficients module 136, a samples location module 138, a buffer 140, and an interpolation module 142.

FIR3 129, which may be a finite impulse response filter, may be used for interpolation of the interpolated sample signal generated by FIR2 116. The samples generated by FIR3 129 may be approximated samples of the interpolated samples of FIR 2 116, but may be shifted by T/4 to obtain a quadrature component for more accurate interpolation. FIR3 129 may be a relatively accurate interpolator or alternatively, a relatively rough interpolator. For example, cubic interpolation may be used for accurate interpolation while rough interpolation may be done using a relatively simple linear interpolator, for example, described by:

$$y(n) = \frac{x(n) + x(n-1)}{2} \qquad (5)$$

where samples $x$ are samples at a distance of $T/2$.

PD3 131 may be similar to PD1 112 and PD2 118 and may generate a quasi-cosinusoidal output (due to the T/4 shift from FIR3 129). PD3 131 output may be described by:

$$y_{out}(n) = abs\left(z(n)\right)^k sign(z(n))sign(z(n+2)) - abs\left(z(n+2)\right)^k sign(z(n+2))sign(z(n)) \qquad (6)$$

where samples z are samples at a distance of $T/2$. It may be noted that only every second sample is used in PD2 118 and PD3 131.

The quasi-sinusoidal output from PD2 118 and the quasi-cosinusoidal output from PD3 131 output may be used in an interpolator LUT 132 which may be configured to output the sampling phase. LUT 132 may be configured to output a phase angle responsive to the inputs from PD2 118 and PD3 131, which may be described by:

$$\theta(n) = angle(g \cdot PD2_{out} / PD3_{out}) \qquad (7)$$

where the parameter g may add linearity to the interpolator transfer function. This may be required since the outputs of PD2 118 and PD3 131 may be of a different nature. The selection of value g may depend on the structure of FIR3 129.

LUT 132 output may be processed by unwrap module 134 to enable phase tracking over more symbol intervals. Unwrap module 134 output may be used by samples location module 138 to calculate samples locations and by interpolator coefficients module 136 to calculate interpolator coefficients. The samples locations may be output to buffer 140 which may output samples to interpolator module 140, which may use the interpolator coefficients from interpolator coefficients module 136 to derive the more accurate interpolated samples.

The FIR3, PD3 and LUT are not active when one sample per symbol is available from ADC. The interpolator generates (by interpolation) second samples with some error since the interpolation using one sample per symbol is not successful. Nevertheless, the rough second samples are very useful for channel acquisition using MLSE equalizers.

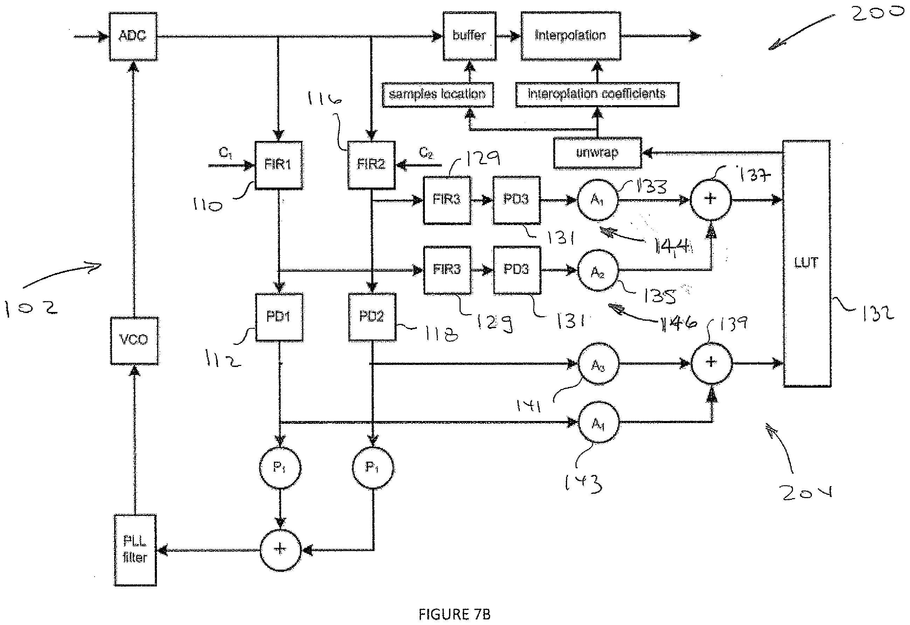

Reference is now made to Figure 7B which schematically illustrates a block diagram of an exemplary TR 200, according to an embodiment of the present invention. TR 200 may include feed-back section 102 and an improved feed-forward section 204 which utilizes the interpolated samples from FIR1 110 and FIR2 116 and the quasi-sinusoidal outputs of PD1 112 and PD2 118. By using all the interpolated samples (from FIR1 110 and from FIR 1 116), TR 200 may provide for a variance in sampling phase estimation which may be approximately twice as good as that of TR 100.

Feed-forward section 204 may include two parallel branches 144 and 146, each branch including FIR3 129 and PD3 131. Branch 144 may approximate the interpolated samples from FIR2 116 and branch 146 may approximate the interpolated samples from FIR1 110, respectively, with a quadrature shift of T/4 so that the outputs from the phase detectors are quasi-cosinusoidal. Branches 144 and 146 may include multipliers A1 133 and A2 135, respectively, to add linearity to the quasi-cosinusoidal outputs from PD3 133 in each branch. A combiner 137 may add the outputs of branches 144 and 146 which may be fed to LUT 132 for determining the sampling phase. The in-phase component may be provided by PD1 112 and PD2 118, the quasi-sinusoidal outputs combined by a combiner 139 and output to LUT 132. Prior to combining, the quasi-sinusoidal output from PD2 118 may be adjusted to add linearity by a multiplier A3 141 and the quasi-sinusoidal output from PD1 112 may be adjusted by a multiplier A4 143.

Applicants have realized that the TRs shown in Figures 7A and 7B may be simplified when interpolation becomes expensive and/or jitter tolerance requirements are not substantially critical. The PLL delay (in feedback section 102) may be made relatively small so that an expensive interpolator may not be required. Nevertheless, in MLSE equalized receivers, one may still need to optimize sampling phase. The selection of the optimal sampling phase may be based on FEC information about the number of corrected errors. The number of corrected errors may additionally be roughly estimated by the MLSE equalizer.

System performance may be significantly improved when the correct sampling phase is chosen, particularly in MLSE equalizers using one sample per symbol. The sampling phase may be adjusted with greed of 180° when the ADC delivers one sample per symbol and with greed of 90° when two samples are available. In the one sample per symbol case, the sampling phase shift by 180° may be achieved by inverting the signs of parameters $P_1$ and $P_2$. Better results may be achieved when FIR1 and FIR2 are exchanged, that is, when the FIR1 transfer function is $(1+D)^{2n+1}$ and the FIR2 transfer function is $(1+D)^{2n}$. With two samples per symbol, the sampling phase adjustment may be achieved using the rules shown in Table 1 below. Unlike the one sample per symbol scenario, the FIR1 and FIR2 structures may be combined via the signs of parameters $P_1$ and $P_2$.

Table 1 sampling phase adjustment in systems using two samples per symbol

| phase(°) | FIR1 | FIR2 | sign($P_1$) | sign($P_2$) |
|---|---|---|---|---|
| 0 | $(1+D)^{2n}$ | $(1+D)^{2n+1}$ | + | + |
| 90 | $(1+D)^{2n+1}$ | $(1+D)^{2n}$ | + | + |
| 180 | $(1+D)^{2n}$ | $(1+D)^{2n+1}$ | - | - |
| 270 | $(1+D)^{2n+1}$ | $(1+D)^{2n}$ | - | - |

Simulation Results

Applicants simulated a 28Gb/s OOK IM/DD transmission system over a CD range from 0 to 2000ps/nm. OSNR was set to 22dB. Two samples per symbols were used. FIR1 and FIR2 coefficients were set to (1, 4, 6, 4, 1). The parameters $P_1$ and $P_2$ were optimized for each transmission scenario. Phase detector parameter k in equation (4) above was set to 0.5. PLL damping factor was fixed to 0.707 while PLL bandwidths were set to 1, 2, and 4 MHz.

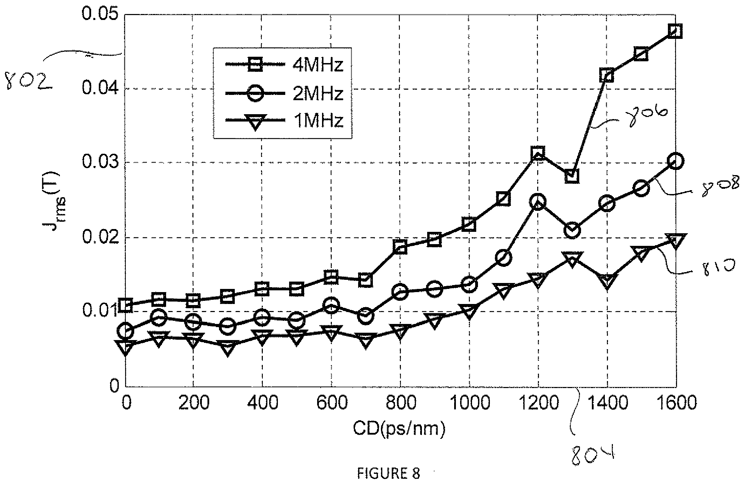

The root mean square jitter ($J_{rms}$) simulation results are shown in Figure 8 which illustrates $J_{rms}(T)$ on a vertical scale 802 plotted against chromatic dispersion CD (ps/nm) on a horizontal axis 804 for the different PLL bandwidths, according to an embodiment of the present invention. The simulation results show jitter in the 4MHz PLL bandwidth was close to $0.05T$, as indicated by curve 806. This may be translated to a peak-to-peak jitter ($J_{pp}$) in one year (for a 28Gb/s system) of approximately 8 $J_{rms}$ (0.4), which may acceptable for practical systems. To improve random jitter performance at the expense of decreasing jitter tolerance requirements, the PLL loop (feedback section) bandwidth may be designed to be 2 MHz or even 1MHz. For a 2 MHz PLL bandwidth, jitter is reduced to 0.03T, as indicated by curve 808. For the 1 MHz PLL bandwidth, jitter is only $0.02T$, as shown by curve 810, and $J_{pp}$ in one year is 0.16T. Increasing jitter may be equivalent to noise enhancement and may cause the sampling phase to vary in time, causing changes to the channel model used in equalizers. The sampling phase variations may be equivalent to increasing noise deviation, and may require system design to consider trade-offs between jitter tolerance and deterministic jitter-free BER performance.

Actual Test Results

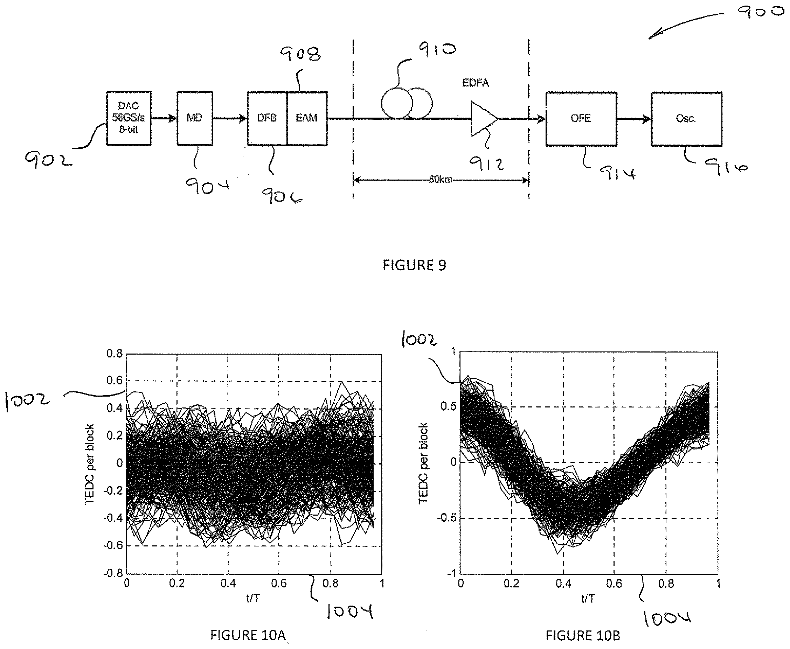

Applicants conducted tests with signals received over an 80 km DC uncompensated optical link. Figure 9 schematically illustrates a block diagram optical transmission system 900 test set-up, according to an embodiment of the present invention. Optical transmission system 900 included a 56 G/s 8-bit resolution DAC (digital to analog converter) 902, a MD 904, a DFB 906, an EAM 908, 80 km optical fiber link 910, an EDFA 912, an OFE 914, and an oscilloscope 916.

A 28 Gb/s electrical signal was generated using DAC 904. The transmitter generated an OOK optical signal with a bandwidth of approximately 10GHz. The signal was sent over 80km link 910 which included one EDFA 912. EDFA 912 was used to adjust the input optical power to 8dBm. After receiving the optical signal, data was captured by oscilloscope 916 and processed off-line using a PC. The measured CD was around 1300 ps/nm. Simulated $J_{rms}$ for PLL bandwidths of 1, 2 and 4 MHz were 0.017, 0.023, and 0.031, respectively, substantially confirming the simulation results shown in Figure 8. In the test, TEDC was estimated over 1024 symbols for a MMPD and for a new PD including a timing recovery circuit according to an embodiment of the present invention. 256 TEDC curves are presented in Figures 10A and 10B for the MMPD and for the new PD, respectively, which plot TEDC per block on a vertical axis 1002 against t/T in a horizontal axis 1004. As may be appreciated from Figure 10A, the PLL (feedback section) output in the MMPD is noisy and cannot be used for timing recovery. In Figure 10B, the PLL output of the new PD is shown to be quasi-sinusoidal which may be suitable for controlling a VCO.

Unless specifically stated otherwise, as apparent from the preceding discussions, it is appreciated that, throughout the specification, discussions utilizing terms such as "processing," "computing," "calculating," "determining," or the like, refer to the action and/or processes of a computer, computing system, or similar electronic computing device that manipulates and/or transforms data represented as physical, such as electronic, quantities within the computing system's registers and/or memories into other data similarly represented as physical quantities within the computing system's memories, registers or other such information storage, transmission or display devices.

Embodiments of the present invention may include apparatus for performing the operations herein. This apparatus may be specially constructed for the desired purposes, or it may comprise a general-purpose computer selectively activated or reconfigured by a computer program stored in the computer. Such a computer program may be stored in a computer readable storage medium, such as, but not limited to, any type of disk, including floppy disks, optical disks, magnetic-optical disks, read-only memories (ROMs), compact disc read-only memories (CD-ROMs), random access memories (RAMs), electrically programmable read-only memories (EPROMs), electrically erasable and programmable read only memories (EEPROMs), magnetic or optical cards, Flash memory, or any other type of media suitable for storing electronic instructions and capable of being coupled to a computer system bus.

The processes and displays presented herein are not inherently related to any particular computer or other apparatus. Various general-purpose systems may be used with programs in accordance with the teachings herein, or it may prove convenient to construct a more specialized apparatus to perform the desired method. The desired structure for a variety of these systems will appear from the description below. In addition, embodiments of the present invention are not described with reference to any particular programming language. It will be appreciated that a variety of programming languages may be used to implement the teachings of the invention as described herein.

While certain features of the invention have been illustrated and described herein, many modifications, substitutions, changes, and equivalents will now occur to those of ordinary skill in the art.

## Claims

1.    A timing recovery apparatus for receivers, the apparatus comprising:

    an analog-to digital converter, ADC, (106) a voltage controlled oscillator, VCO, (130), connected to an input of the ADC,
    a feedback loop (108; 114) comprising two parallel branches, each branch connected to an output of the ADC and each branch comprising at least one interpolation filter and one phase detector (112; 118);
    a combiner (126) in said feedback loop to combine a signal from each of said branches, the output of the combiner connected to the VCO; and
    a feed-forward section comprising at least one interpolation filter and one phase detector, wherein an input of said at least one interpolation filter is connected to an output of said at least one interpolation filter in at least one of said parallel branches of the feedback loop.

2.    A timing recovery apparatus according to claim 1, wherein said at least one interpolation filter in each of said branches comprises a finite impulse response filter (110; 116).

3.    A timing recovery apparatus according to claim 1 or 2, wherein each of said branches further comprises a multiplier (120; 122) to adjust the outputs of said phase detectors.

4.    A timing recovery apparatus according to one of claims 1 - 3, wherein said feedback loop further comprises a phase-locked loop filter (128).

5.    A timing recovery apparatus according to claim 1 wherein said feed-forward section further comprises a look-up table for interpolating a sampling phase.

## Patentansprüche

1.    Timingrückgewinnungsvorrichtung für Empfänger, wobei die Vorrichtung Folgendes umfasst:

    einen Analog-Digital-Wandler, ADC, (106), einen spannungsgesteuerten Oszillator, VCO, (130), verbunden mit einem Eingang des ADC,
    eine Rückkopplungsschleife (108; 114), umfassend zwei Parallelzweige, wobei jeder Zweig mit einem Ausgang des ADC verbunden ist und jeder Zweig mindestens ein Interpolationsfilter und einen Phasendetektor (112; 118) umfasst;
    einen Kombinierer (126) in der Rückkopplungsschleife zum Kombinieren eines Signals von jedem der Zweige, wobei der Ausgang des Kombinierers mit dem VCO verbunden ist; und
    eine Vorwärtskopplungssektion, umfassend mindestens ein Interpolationsfilter und einen Phasendetektor, wobei ein Eingang des mindestens einen Interpolationsfilters mit einem Ausgang des mindestens einen Interpolationsfilters in mindestens einem der Parallelzweige der Rückkopplungsschleife verbunden ist.

**2.** Timingrückgewinnungsvorrichtung nach Anspruch 1, wobei das mindestens eine Interpolationsfilter in jedem der Zweige ein Filter mit endlicher Impulsantwort (110; 116) ist.

**3.** Timingrückgewinnungsvorrichtung nach Anspruch 1 oder 2, wobei jeder der Zweige ferner einen Multiplizierer (120; 122) zum Einstellen der Ausgänge des Phasendetektors umfasst.

**4.** Timingrückgewinnungsvorrichtung nach einem der Ansprüche 1 - 3, wobei die Rückkopplungsschleife ferner ein Phasenregelschleifenfilter (128) umfasst.

**5.** Timingrückgewinnungsvorrichtung nach Anspruch 1, wobei die Vorwärtskopplungssektion ferner eine Nachschlagetabelle zum Interpolieren einer Abtastphase umfasst.

**Revendications**

**1.** Appareil de récupération de rythme destiné à des récepteurs, l'appareil comprenant :

un convertisseur analogique/numérique, CAN (106), un oscillateur commandé par tension, VCO (130), relié à une entrée du CAN, une boucle de rétroaction (108 ; 114) comprenant deux branches parallèles, chaque branche étant reliée à une sortie du CAN et chaque branche comprenant au moins un filtre d'interpolation et un détecteur de phase (112 ; 118) ;
un combineur (126) placé dans ladite boucle de rétroaction pour combiner un signal provenant de chacune desdites branches, la sortie du combineur étant reliée au VCO ; et
une section de correction aval comprenant au moins un filtre d'interpolation et un détecteur de phase, une entrée dudit au moins un filtre d'interpolation étant reliée à une sortie dudit au moins un filtre d'interpolation dans au moins une desdites branches parallèles de la boucle de rétroaction.

**2.** Appareil de récupération de rythme selon la revendication 1, dans lequel ledit au moins un filtre d'interpolation de chacune desdites branches comprend un filtre à réponse impulsionnelle finie (110 ; 116).

**3.** Appareil de récupération de rythme selon la revendication 1 ou 2, dans lequel chacune desdites branches comprend un multiplicateur (120 ; 122) servant à régler les sorties desdits détecteurs de phase.

**4.** Appareil de récupération de rythme selon l'une quelconque des revendications 1 à 3, dans lequel ladite boucle de rétroaction comprend un filtre à boucle à verrouillage de phase (128).

**5.** Appareil de récupération de rythme selon la revendication 1, dans lequel ladite section de correction aval comprend une table de consultation permettant d'interpoler une phase d'échantillonnage.

PRIOR ART

FIGURE 1

PRIOR ART

FIGURE 2

EP 3 158 676 B1

FIGURE 3

FIGURE 4

FIGURE 5

FIGURE 6

FIGURE 7A

FIGURE 7B

FIGURE 8

FIGURE 9

FIGURE 10A

FIGURE 10B

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 8466713 B2

- US 20080232531 A1

### Non-patent literature cited in the description

- **MUELLER, K. H. ; M. S. MULLER.** Timing Recovery in Digital Synchronous Data Receivers. *IEEE Transactions on Communications,* 1976, vol. 24, 516-531

- **ALEXANDER, J.D.H.** Clock Recovery from Random Binary Signals. *Electronic Letters,* 1975, vol. 11, 22, 540-541
- **GARDNER, F.** A BPSK/QPSK Timing-Error Detector for Sampled Receivers. *IEEE Transactions on Communications,* 1986, vol. 34, 423-429